(19) Europäisches Patentamt
European Patent Office
Office européen des brevets

(11) **EP 3 223 025 B1**

(12) **EUROPEAN PATENT SPECIFICATION**

(45) Date of publication and mention of the grant of the patent:
**17.07.2019 Bulletin 2019/29**

(21) Application number: **14906303.4**

(22) Date of filing: **21.11.2014**

(51) Int Cl.:
*G01R 31/08* (2006.01)    *G01R 31/12* (2006.01)
*H02B 13/065* (2006.01)    *H02G 5/06* (2006.01)

(86) International application number:
**PCT/JP2014/080939**

(87) International publication number:
**WO 2016/079869 (26.05.2016 Gazette 2016/21)**

(54) **PARTIAL DISCHARGE POSITION LOCATION DEVICE**

VORRICHTUNG ZUR TEILENTLADUNGSPOSITIONSBESTIMMUNG

DISPOSITIF DE LOCALISATION DE POSITION DE DÉCHARGE PARTIELLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.09.2017 Bulletin 2017/39**

(73) Proprietor: **Mitsubishi Electric Corporation Chiyoda-ku Tokyo 100-8310 (JP)**

(72) Inventor: **TAMURA, Yoshiyuki Tokyo 100-8310 (JP)**

(74) Representative: **Mewburn Ellis LLP City Tower 40 Basinghall Street London EC2V 5DE (GB)**

(56) References cited:
**WO-A1-2009/005223    JP-A- H1 152 003
JP-A- H08 178 997    JP-A- H09 159 717
JP-A- S62 140 074    JP-A- S63 193 077
JP-A- 2003 084 027    US-A1- 2012 022 810**

**Description**

Field

The present invention relates to a partial discharge locating apparatus for locating a partial discharge that has occurred in a gas-insulated apparatus or a power cable.

Background

Conventional partial discharge locating apparatuses have two partial discharge sensors installed in a gas-insulated apparatus or on a power cable, measure a detection time difference of a partial discharge signal detected by the partial discharge sensors, and locate occurrence of the partial discharge using the detection time difference.

In locating a partial discharge that has occurred in a gas-insulated apparatus, a partial discharge signal can be detected in both a low-frequency band (several MHz to tens of MHz) and a high-frequency band (tens of MHz to more than 1 GHz) as the partial discharge has occurred in an insulating gas. Detecting the partial discharge signal in the high-frequency band (tens of MHz to more than 1 GHz) enables locating the partial discharge at a high signal-to-noise ratio. At this time, partial discharge sensors are typically internal sensors mounted to the gas-insulated apparatus or antennas mounted on exposed spacers.

On the other hand, in locating a partial discharge that has occurred in a power cable, a partial discharge signal is in a low-frequency band (several MHz to tens of MHz) as the partial discharge has occurred in an insulator in the power cable. At these frequencies, the effect of noise is large, and thus it is required to distinguish between the partial discharge signal and the noise.

Partial discharge diagnosis and location are usually performed in actually operating states of apparatuses. A system that enables the frequency used in partial discharge diagnosis and location to be easily changed in the field is desirable because noise varies depending on environment.

Typically, suppliers of gas-insulated apparatuses and power cables are different. Thus, identifying whether a partial discharge has occurred in a gas-insulated apparatus or in a power cable is important information in restoration work.

Patent Literature 1 is directed to partial discharge detection in a power cable. The technique disclosed in Patent Literature 1 determines the frequency spectrum of noise by a spectrum analyzer using a superheterodyne frequency sweep tuned amplifier, inputs a calibration pulse into the power cable to measure a detected output by the spectrum analyzer, and compares the frequency spectrum of the noise with the detected output of the calibration pulse input into the power cable, such that the frequency providing the highest signal-to-noise ratio is used to detect the partial discharge.

Patent Literature 2 discloses a technique inputting the outputs of two detectors to a frequency selector, using peak position detection circuits to detect the respective peaks of partial discharge signals that have the frequencies selected by the frequency selector, using a time difference detection circuit to detect the time difference between the both peaks, and using the time difference to locate the partial discharge that has occurred in a power cable or a gas-insulated apparatus. The frequency selector is a bandpass filter or a heterodyne detector.

Citation List

Patent Literature

Patent Literature 1: JP 04-070573 A
Patent Literature 2: JP 09-229991 A

JPH09159717 A discloses a method and device for detecting a discharging position.

Summary

Technical Problem

Conventional partial discharge locating apparatuses are different for gas-insulated apparatuses and for power cables. In order to identify whether a partial discharge has occurred in a gas-insulated apparatus or in a power cable, it is required to locate the partial discharge in the gas-insulated apparatus by using the partial discharge locating apparatus for the gas-insulated apparatus, and locate the partial discharge in the power cable by using the partial discharge locating apparatus for the power cable.

On the other hand, the same partial discharge locating apparatus can be used for the gas-insulated apparatus and the power cable. In this case, however, locating the partial discharge in the gas-insulated apparatus and locating the partial discharge in the power cable need to be performed using the same partial discharge locating apparatus.

That is, it has been required to perform the two partial discharge measurements to identify whether the partial discharge has occurred in the gas-insulated apparatus or in the power cable.

The conventional technique described in Patent Literature 1 is a method used in factory tests on power cables as can be seen from the fact that this technique requires the step of inputting a calibration pulse into a power cable, and is not intended to be applied to a gas-insulated apparatus in operation, and further, is not intended to locate the partial discharge.

On the other hand, the conventional technique described in Patent Literature 2, which is directed to locating the partial discharge, requires the two partial discharge measurements that locate the partial discharge in the gas-insulated apparatus and locate the partial discharge in the power cable, as described above, in order to identify whether a partial discharge has occurred in a gas-insulated apparatus or in a power cable.

The present invention has been made in view of the above, and has an object to provide a partial discharge locating apparatus capable of identifying, by the single measurement, in which one of the gas-insulated apparatus and the power cable the partial discharge has occurred.

Solution to Problem

To solve the above problem and object, a partial discharge locating apparatus according to the present invention is a partial discharge locating apparatus as set out in claim 1.

Advantageous Effects of Invention

The present invention achieves an effect of identifying, by the single measurement, in which one of the gas-insulated apparatus and the power cable the partial discharge has occurred.

Brief Description of Drawings

FIG. 1 is a diagram illustrating an example of a configuration of an apparatus to which a partial discharge locating apparatus according to an embodiment is applied.

FIG. 2 is a diagram illustrating mounting modes of foil electrodes.

FIG. 3 is a block diagram illustrating an example of a configuration of the partial discharge locating apparatus according to the embodiment.

FIG. 4 is a graph illustrating an example of an output waveform of each of a SAW filter 6a, an absolute value circuit 8a, an AGC circuit 9a, and a comparator 10a.

FIG. 5 is a graph illustrating an example of an output waveform of each of a SAW filter 6b, an absolute value circuit 8b, an AGC circuit 9b, and a comparator 10b.

FIG. 6 is a graph illustrating another example of an output waveform of the SAW filter 6a.

FIG. 7 is a graph illustrating a manner in which the time difference $\Delta t$ between detection times t1 and t2 of a partial discharge signal is determined from the outputs of the comparators 10a and 10b.

FIG. 8 is a diagram for explaining a method of calculating the location of occurrence of a partial discharge.

FIG. 9 is a graph illustrating an example of the relationship between a time difference and X when L1 is equal to 10 m (L1 = 10 m) and L2 is equal to 15 m (L2 = 15 m) in FIG. 8.

Description of Embodiment

Hereinafter, an embodiment of a partial discharge locating apparatus according to the present invention will be described in detail with reference to the drawings. The embodiment is not intended to limit the invention.

Embodiment.

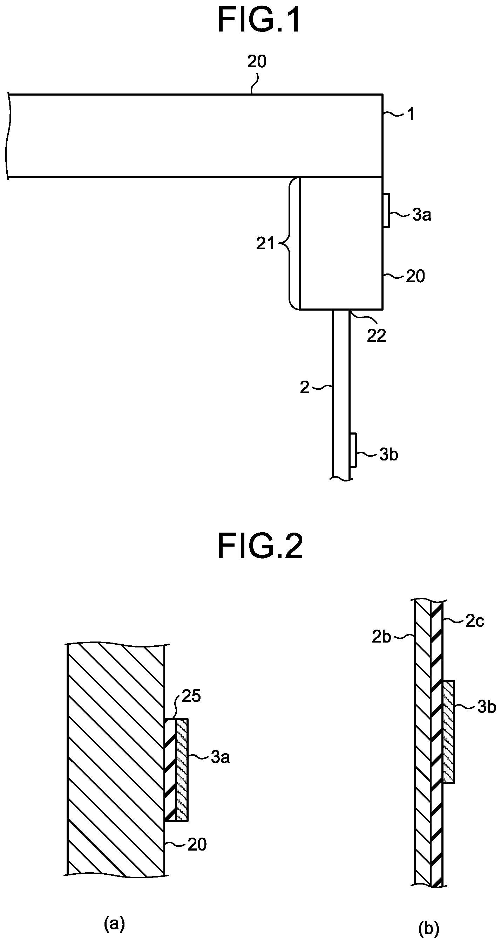

FIG. 1 is a diagram illustrating an example of a configuration of an apparatus to which the partial discharge locating apparatus according to the present embodiment is applied. As illustrated in FIG. 1, a power cable 2 is connected to a gas-insulated apparatus 1. The gas-insulated apparatus 1 is configured by a metal container 20 housing an energized section (not illustrated) and confining an insulating gas. Commercial-frequency current flows through the energized section. The gas-insulated apparatus 1 has a cable head 21. A connection end 22 of the power cable 2 to the gas-insulated apparatus 1 is connected to the cable head 21.

The power cable 2 is a coaxial cable having a conductive core (not illustrated), an insulator (not illustrated) covering the outer periphery of the core, a conductive braided wire covering the outer periphery of the insulator, and an insulating sheath covering the periphery of the braided wire. Here, the insulator is made of typically cross-linked polyethylene. As described below, the braided wire is denoted by reference numeral "2b" in FIG. 2, and the sheath is denoted by reference numeral "2c" in FIG. 2. The energized section of the gas-insulated apparatus 1 is electrically connected to the core of the power cable 2. The metal container 20 and the braided wire of the power cable 2 are grounded.

A foil electrode 3a that is a first sensor capable of detecting partial discharge signals is mounted to the gas-insulated apparatus 1. A foil electrode 3b that is a second sensor capable of detecting partial discharge signals is mounted to the power cable 2.

FIG. 2 is a diagram illustrating mounting modes of the foil electrodes 3a and 3b. Specifically, FIG. 2(a) illustrates the mounting mode of the foil electrode 3a, and FIG. 2(b) illustrates the mounting mode of the foil electrode 3b. FIG. 2(a) illustrates only a part of a vertical cross section of the metal container 20, and FIG. 2(b) illustrates only a part of a vertical cross section of the power cable 2.

As illustrated in FIG. 2(a), the foil electrode 3a is mounted on the metal container 20 via an insulator 25. The foil electrode 3a, which is a metal electrode in the form of a foil, a sheet, or a thin plate, is formed of copper, for example. The insulator 25 is held between the foil electrode 3a and the metal container 20. The foil electrode 3a can be stuck to the metal container 20 with tape, for example. Using the foil electrode 3a as the first sensor facilitates the mounting and demounting of the first sensor. The foil electrode 3a, the metal container 20, and the insulator 25 constitute a capacitor.

As illustrated in FIG. 2(b), the foil electrode 3b is mounted on the sheath 2c of the power cable 2. The foil electrode 3b can be of the same size, shape, and material as the foil electrode 3a. Since the sheath 2c is formed of an insulator, even when the foil electrode 3b is disposed directly on the sheath 2c as in the illustrated example, the foil electrode 3b and the braided wire 2b and the sheath 2c of the power cable 2 constitute a capacitor. The foil electrode 3b can be stuck to the power cable 2 with tape like the foil electrode 3a. Using the foil electrode 3b as the second sensor facilitates the mounting and demounting of the second sensor.

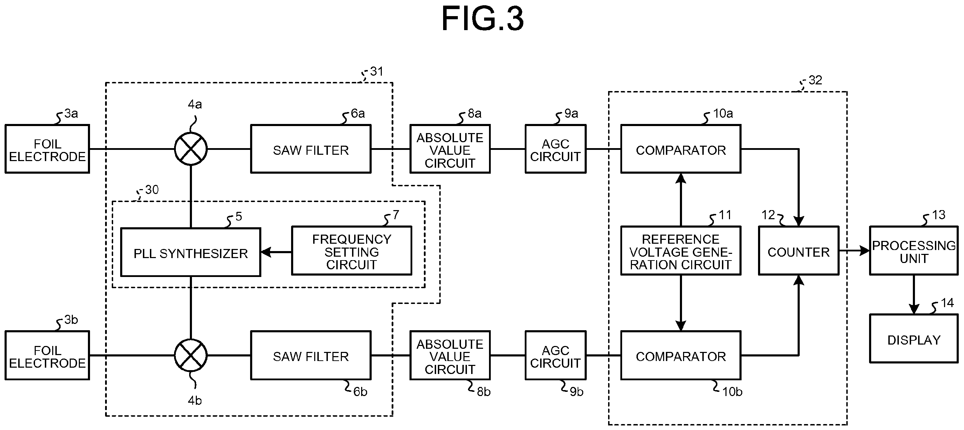

FIG. 3 is a block diagram illustrating an example of a configuration of the partial discharge locating apparatus according to the present embodiment. The partial discharge locating apparatus according to the present embodiment includes the foil electrodes 3a and 3b, mixers 4a and 4b, a phase-locked loop (PLL) synthesizer 5, a frequency setting circuit 7, surface acoustic wave (SAW) filters 6a and 6b, absolute value circuits 8a and 8b, automatic gain control (AGC) circuits 9a and 9b, comparators 10a and 10b, a reference voltage generation circuit 11, a counter 12, a processing unit 13, and a display 14.

The foil electrode 3a is connected to the mixer 4a, and the output of the foil electrode 3a is input to the mixer 4a. Likewise, the foil electrode 3b is connected to the mixer 4b, and the output of the foil electrode 3b is input to the mixer 4b. The foil electrode 3a detects a partial discharge signal when a partial discharge has occurred in the gas-insulated apparatus 1 or in the power cable 2, and outputs the partial discharge signal to the mixer 4a. Likewise, the foil electrode 3b detects a partial discharge signal when a partial discharge has occurred in the gas-insulated apparatus 1 or in the power cable 2, and outputs the partial discharge signal to the mixer 4b.

The PLL synthesizer 5 is connected to the mixers 4a and 4b. The PLL synthesizer 5 is a frequency synthesizer using the PLL method. The PLL synthesizer 5 generates a local oscillator signal that is a signal of a local oscillation frequency set in the frequency setting circuit 7, and outputs the local oscillation signal to the mixers 4a and 4b. The local oscillation signal is, for example, a sinusoidal wave or a cosine wave. The PLL synthesizer 5 and the frequency setting circuit 7 constitute a local oscillator 30.

The mixer 4a is connected to the SAW filter 6a. The mixer 4a, which is a first mixer, mixes the output of the foil electrode 3a with the output of the PLL synthesizer 5. Specifically, the mixer 4a multiplies the output of the foil electrode 3a by the output of the PLL synthesizer 5, and outputs the product of the outputs to the SAW filter 6a. The SAW filter 6a, which is a first filter, allows passage of only a component of a passing frequency of the output of the mixer 4a. The passing frequency is described later. The SAW filter 6a is a narrow-band filter. The passing frequency is the center frequency of the frequency band of the SAW filter 6a. Likewise, the mixer 4b is connected to the SAW filter 6b. The mixer 4b, which is a second mixer, mixes the output of the foil electrode 3b with the output of the PLL synthesizer 5. Specifically, the mixer 4b multiplies the output of the foil electrode 3b by the output of the PLL synthesizer 5, and outputs the product of the outputs to the SAW filter 6b. The SAW filter 6b, which is a second filter, allows passage of only a component of a passing frequency of the output of the mixer 4b. Here, the SAW filter 6b has the same passing frequency as the SAW filter 6a.

The mixers 4a and 4b, the local oscillator 30, and the SAW filters 6a and 6b constitute a frequency selecting unit 31. The frequency selecting unit 31 selects and outputs a component of a detection frequency from the partial discharge signal output from the foil electrode 3a, and selects and outputs a component of the same detection frequency from the partial discharge signal output from the foil electrode 3b. Here, the detection frequency is a predetermined frequency used for the detection of the partial discharge signal, and is the common frequency to the foil electrodes 3a and 3b.

The absolute value circuit 8a is connected to an output stage of the SAW filter 6a. The absolute value circuit 8a, which is a first absolute value circuit, outputs the absolute value of the output of the SAW filter 6a. Likewise, the absolute value circuit 8b is connected to an output stage of the SAW filter 6b. The absolute value circuit 8b, which is a second absolute value circuit, outputs the absolute value of the output of the SAW filter 6b.

The AGC circuit 9a is connected to an output stage of the absolute value circuit 8a. The AGC circuit 9a, which is a first amplitude adjustment circuit, automatically adjusts a gain relative to the output of the absolute value circuit 8a to adjust the amplitude of the output of the absolute value circuit 8a to a predetermined fixed magnitude. Likewise, the AGC circuit 9b is connected to an output stage of the absolute value circuit 8b. The AGC circuit 9b, which is a second amplitude adjustment circuit, automatically adjusts a gain relative to the output of the absolute value circuit 8b to adjust the amplitude of the output of the absolute value circuit 8b to the same magnitude as the amplitude of the output of the absolute value circuits 8a. That is, the AGC circuits 9a and 9b normalize the amplitudes of the outputs of the absolute value circuits 8a and 8b. This normalization of the amplitude reduces the effect of the attenuation of the partial discharge signal due to the propagation and magnitude of the partial discharge, thus improving the locating accuracy.

The comparator 10a is connected to an output stage of the AGC circuit 9a. The comparator 10a, which is a first comparator, compares the output of the AGC circuit 9a with a reference voltage generated in the reference voltage generation circuit 11, and outputs different values depending on whether the output of the AGC circuit 9a is larger or smaller than the reference voltage. For example, when the output of the AGC circuit 9a is larger than the reference voltage, the comparator 10a outputs VH. When the output of the AGC circuit 9a is smaller than the reference voltage, the comparator 10a outputs VL (< VH). Here, the reference voltage is set to a value larger than the magnitude of noise at the detection frequency. The magnitude of noise is estimated under an environment where the gas-insulated apparatus 1 is actually operated. Therefore, the partial discharge signal is detected when the output of the comparator 10a goes from the VL to the VH. That time is the time of detection of the partial discharge signal by the foil electrode 3a.

Likewise, the comparator 10b is connected to an output stage of the AGC circuit 9b. The comparator 10b, which is a second comparator, compares the output of the AGC circuit 9b with a reference voltage generated in the reference voltage generation circuit 11, and outputs different values depending on whether the output of the AGC circuit 9b is larger or smaller than the reference voltage. The magnitude of the reference voltage output from the reference voltage generation circuit 11 to the comparator 10b is equal to the magnitude of the reference voltage output from the reference voltage generation circuit 11 to the comparator 10a. For example, when the output of the AGC circuit 9b is larger than the reference voltage, the comparator 10b outputs VH. When the output of the AGC circuit 9b is smaller than the reference voltage, the comparator 10b outputs VL (< VH). Therefore, the partial discharge signal is detected when the output of the comparator 10b goes from the VL to the VH. That time is the time of detection of the partial discharge signal by the foil electrode 3b.

The counter 12 is connected to output stages of the comparators 10a and 10b. The counter 12 counts the difference between times at which the partial discharge signal is detected by the foil electrodes 3a and 3b, on the basis of the output of the comparator 10a and the output of the comparator 10b. That is, the counter 12 is a circuit for counting the time difference between a detection time at which the partial discharge signal is detected in one of the comparators 10a and 10b and a detection time at which the partial discharge signal is detected in the other of the comparators 10a and 10b. The counter 12 outputs the counted time difference.

The comparators 10a and 10b, the reference voltage generation circuit 11, and the counter 12 constitute a time difference detecting unit 32 for detecting a time difference that is a difference between the time of detection of the partial discharge signal by the foil electrode 3a and the time of detection of the partial discharge signal by the foil electrode 3b. The time difference is the difference in time at which the partial discharge signal reaches the foil electrodes 3a and 3b.

The processing unit 13 is connected to an output stage of the counter 12. The processing unit 13 is a calculator that is, for example, a microcomputer. The time difference, which is the output of the counter 12, is input to the processing unit 13. As described below, the processing unit 13 locates occurrence of a partial discharge, on the basis of the time difference, the propagation velocity of the partial discharge signal in the gas-insulated apparatus 1, and the propagation velocity of the partial discharge signal in the power cable 2. The display 14 is connected to the processing unit 13. On the display 14, the location of occurrence of the partial discharge determined by the processing unit 13 is displayed.

Next, an operation of the present embodiment will be described. The energized portion of the gas-insulated apparatus 1 is connected to the core of the power cable 2, and the metal container 20 of the gas-insulated apparatus 1 and the braided wire of the power cable 2 are grounded. Even when a partial discharge occurs in either the gas-insulated apparatus 1 or the power cable 2, thus, the partial discharge is propagated to the other, assuming that the partial discharge has occurred between the foil electrodes 3a and 3b. This setting is always possible by adjusting the mounting positions of the foil electrodes 3a and 3b.

When the partial discharge occurs in the gas-insulated apparatus 1 or in the power cable 2, the partial discharge is propagated through the gas-insulated apparatus 1 and the power cable 2, and reaches the installation positions of the foil electrodes 3a and 3b. The foil electrodes 3a and 3b individually detect the partial discharge signal.

The mixer 4a multiplies the output of the foil electrode 3a by the local oscillation signal output from the PLL synthesizer 5. The product of the output of the foil electrode 3a and the local oscillation signal is output from the mixer 4a. The output of the mixer 4a is input to the SAW filter 6a. The SAW filter 6a allows the passages of only the component of the passing frequency of the output of the mixer 4a. The output of the mixer 4a has the component of frequency (f0 + f) and the component of frequency (f0 - f) where f is the detection frequency of the partial discharge signal, and f0 is the local oscillation frequency. Thus, in the present embodiment, the passing frequency of the SAW filter 6a is set at (f0 + f).

Likewise, the mixer 4b multiplies the output of the foil electrode 3b by the local oscillation signal output from the PLL synthesizer 5. The product of the output of the foil electrode 3b and the local oscillation signal is output from the mixer 4b. The output of the mixer 4b is input to the SAW filter 6b. The SAW filter 6b allows the passage of only the component of the same pass frequency of the output of the mixer 4b as the SAW filter 6a. The output of the mixer 4b has the component of frequency (f0 + f) and the component of frequency (f0 - f) where f is the detection frequency of the partial discharge signal, and f0 is the local oscillation frequency. The passing frequency of the SAW filter 6b is set to be the same as the passing frequency of the SAW filter 6a.

Thus, the SAW filters 6a and 6b select the upper sidebands of the outputs of the mixers 4a and 4b, and allows the passage of only the components of the specific frequency in the upper sidebands.

When a signal component of 5 MHz only is desired to be taken out from the partial discharge signal, for example, the passing frequency of the SAW filters 6a and 6b is fixed at 30 MHz, and the local oscillation frequency of the PLL synthesizer 5 is set at 25 MHz. The summation of a signal of 5 MHz and a signal of 25 MHz results in the generated frequencies of 30 MHz and 20 MHz. As described above, the present embodiment is configured to select the higher frequency that is 30 MHz. When a signal component of 10 MHz is desired to be taken out from the partial discharge signal, the local oscillation frequency of the PLL synthesizer 5 can be set at 20 MHz.

Thus, selecting the components of the higher frequency (f0 + f) of the outputs of the mixers 4a and 4b by the SAW filters 6a and 6b as discussed above is for increasing the temporal resolution of signal waveforms when the partial discharge locating is performed. That is, using the component of the higher frequency (f0 + f) enables detecting more accurately the rising edge or falling edge of the partial discharge signal, and detecting the detection time of the partial discharge signal with higher accuracy than using the component of the lower frequency (f0 - f).

The reason why the component of the detection frequency is extracted from a partial discharge signal is for locating the partial discharge by using the frequency having a smaller noise in the frequency band of the partial discharge signal that is a low-frequency band (several MHz to tens of MHz) having, in general, large noise due to the environment when the partial discharge occurs in the power cable 2. When the partial discharge signal is generated in the gas-insulated apparatus 1, the frequency band of the partial discharge signal extends over not only the low-frequency band (several MHz to tens of MHz) but also a high-frequency band (tens of MHz to more than 1 GHz). In the present embodiment, the detection frequency of the partial discharge signal is selected from the low-frequency band (several MHz to tens of MHz) with the noise taken into consideration, to enable locating the partial discharge regardless of whether the partial discharge has occurred in the gas-insulated apparatus 1 or in the power cable 2.

Next, the output of the SAW filter 6a is input to the absolute value circuit 8a. The absolute value circuit 8a takes and then outputs the absolute value of the output of the SAW filter 6a. That is, negative voltage values of a voltage signal that has passed through the SAW filter 6a are converted into positive voltage values in the absolute value circuit 8a. Likewise, the output of the SAW filter 6b is input to the absolute value circuit 8b. The absolute value circuit 8b takes and then outputs the absolute value of the output of the SAW filter 6b. That is, negative voltage values of a voltage signal that has passed through the SAW filter 6b are converted into positive voltage values in the absolute value circuit 8b.

Next, the output of the absolute value circuit 8a is input to the AGC circuit 9a. The AGC circuit 9a adjusts the amplitude of the output of the absolute value circuit 8a to a predetermined fixed magnitude. Likewise, the AGC circuit 9b adjusts the amplitude of the output of the absolute value circuit 8b to the fixed magnitude. Thus, the AGC circuits 9a, 9b normalize the amplitudes of the outputs of the absolute value circuits 8a and 8b.

Next, the output of the AGC circuit 9a is input to the comparator 10a. The comparator 10a compares the output of the AGC circuit 9a with the reference voltage generated in the reference voltage generation circuit 11, and outputs the different values depending on whether the output of the AGC circuit 9a is larger or smaller than the reference voltage. Likewise, the output of the AGC circuit 9b is input to the comparator 10b. The comparator 10b compares the output of the AGC circuit 9b with the reference voltage generated in the reference voltage generation circuit 11, and outputs the different values depending on whether the output of the AGC circuit 9b is larger or smaller than the reference voltage.

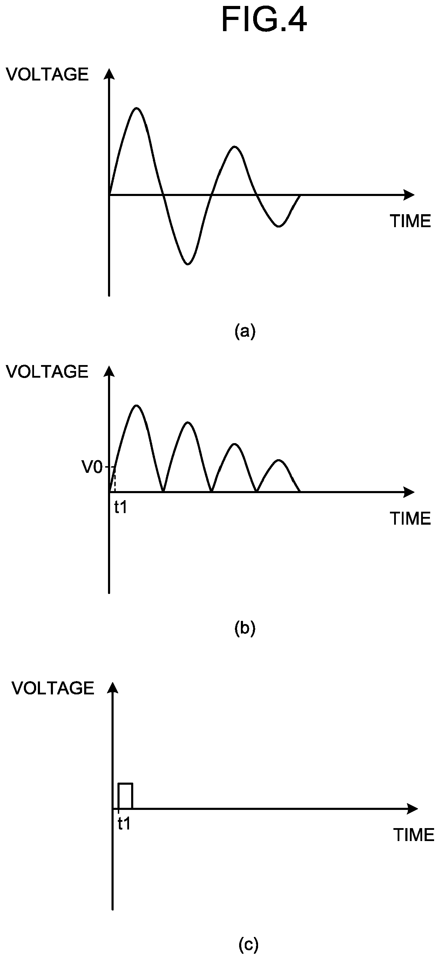

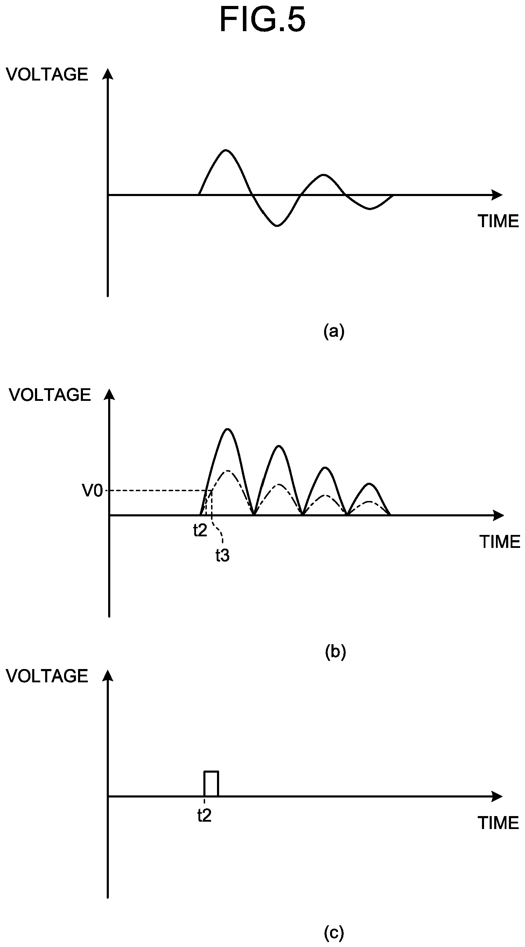

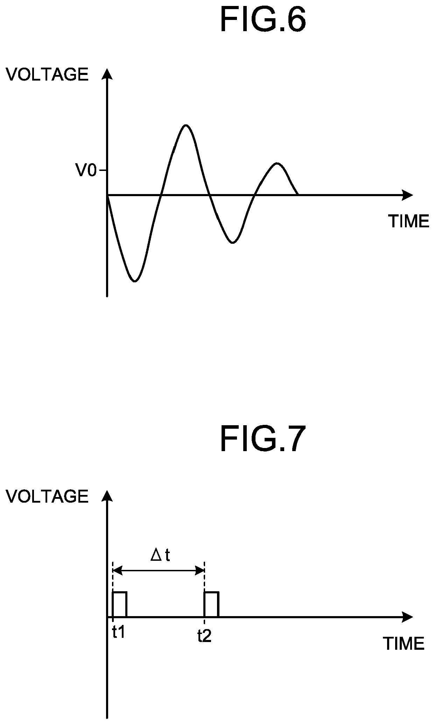

FIG. 4 is a graph illustrating an example of an output waveform of each of the SAW filter 6a, the absolute value circuit 8a, the AGC circuit 9a, and the comparator 10a. FIG. 5 is a graph illustrating an example of an output waveform of each of the SAW filter 6b, the absolute value circuit 8b, the AGC circuit 9b, and the comparator 10b. FIG. 6 is a graph illustrating another example of an output waveform of the SAW filter 6a. In each of FIGS. 4 to 6, the horizontal axis represents the time, and the vertical axis voltage representing the output. The example of FIG. 4 will be discussed on the assumption that the gain of the AGC circuit 9a is set to 1.

Specifically, FIG. 4(a) illustrates an output waveform of the SAW filter 6a. The output waveform represents the partial discharge signal. FIG. 4(b) illustrates the output waveform of the absolute value circuit 8a, in which the negative voltage portions of the output waveform in FIG. 4(a) are reversed to the positive ones. Since the gain of the AGC circuit 9a is set to 1, as described above, the output waveform of the absolute value circuit 8a is equal to the output waveform of the AGC circuit 9a. Therefore, the comparator 10a compares the output waveform in FIG. 4(b) with the reference voltage V0 (> 0). As a result, at a time t1, the output of the comparator 10a changes from the VL to the VH. That is, the time t1 is the time of detection of the partial discharge signal by the foil electrode 3a. FIG. 4(c) illustrates the output waveform of the comparator 10a when the partial discharge signal rises and is detected. In FIG. 4(c), VL = 0.

FIG. 5(a) illustrates the output waveform of the SAW filter 6b. Compared to that in FIG. 4(a), the partial discharge signal arrives late, and the amplitude is different. FIG. 5(b) illustrates the output waveform of the absolute value circuit 8b by the dash-and-dot line, and also illustrates the output waveform of the AGC circuit 9b by the solid line. The amplitude of the output waveform of the AGC circuit 9b is adjusted to be equal to the amplitude of the output waveform of the AGC circuit 9a illustrated in FIG. 4(b). Therefore, the comparator 10b compares the output waveform (solid line) of the AGC circuit 9b with the reference voltage V0. As a result, at a time t2, the output of the comparator 10b changes from the VL to the VH. That is, the time t2 is the time of detection of the partial discharge signal by the foil electrode 3b. FIG. 5(c) illustrates the output waveform of the comparator 10b when the partial discharge signal rises and is detected.

In FIG. 5(b), the time of detection of the partial discharge signal when the output of the absolute value circuit 8b is input to the comparator 10b is denoted by t3. As can be seen from this example, the time t3 is different from the time t2. That is, the inclination of the rising edge of the partial discharge signal in the output waveform of the absolute value circuit 8b is different from that in the output waveform of the AGC circuit 9b, and thus the difference in inclination results in the difference in detection time. Thus, in the present embodiment, the AGC circuits 9a and 9b bring the amplitudes of the output waveforms of the absolute value circuits 8a and 8b to the predetermined fixed amplitude to thereby reduce errors in the times of detection of the partial discharge signal by the foil electrodes 3a and 3b.

The reason why the absolute value circuits 8a and 8b are provided in stages preceding the comparators 10a and 10b is discussed below. The outputs of the mixers 4a and 4b are signals into which the local oscillator signal is modulated with the partial discharge signal. At that time, whether the output waveforms of the mixers 4a and 4b rise to the positive side or fall to the negative side depends on the phase state of the PLL synthesizer 5. FIG. 6 illustrates the output waveform that has been output from the mixer 4a and has passed through the SAW filter 6a, which is an example where the partial discharge signal with the falling egde is detected, unlike the example in FIG. 4. As discussed above, the comparators 10a and 10b in the following stages determine the times of detection of the partial discharge signal by the comparison with the reference voltage V0. When the absolute value circuits 8a and 8b are not provided in the stages preceding the comparators 10a and 10b, the signal detection time for the partial discharge signal of the falling edge is delayed, which results in the factor of the error in the detection time. In other words, the provision of the absolute value circuits 8a and 8b in the stages preceding the comparators 10a and 10b can prevent the delays in the detection times of the partial discharge signal.

Next, the outputs of the comparators 10a and 10b are input to the counter 12. The counter 12 counts the time difference from the detection time at which the partial discharge signal has been detected in one of the comparators 10a and 10b, to the detection time at which the partial discharge signal has been detected in the other of the comparators 10a and 10b.

FIG. 7 is a graph illustrating a manner in which the time difference $\Delta t$ between the detection times t1 and t2 of the partial discharge signal is determined from the outputs of the comparators 10a and 10b. That is, the counter 12 counts the time difference $\Delta t$ from the time t1 at which the partial discharge signal has been detected from the output of the comparator 10a to the time t2 at which the partial discharge signal is detected from the output of the comparator 10b. Which one of the comparators 10a and 10b detects the partial discharge signal earlier depends on the location of occurrence of the partial discharge. With one of the comparators 10a, 10b taken as a reference, therefore, the counter 12 outputs the time difference expressed including the plus or minus sign, from the time at which the partial discharge signal has been detected by the one of the comparators to the time at which the partial discharge signal has been detected by the other comparator. For example, when the comparator 10b is the reference, $\Delta t$ is given by (t1 - t2). In the illustrated example, $\Delta t$ is a negative value.

Next, the output of the counter 12 is input to the processing unit 13. The processing unit 13 locates the occurrence of the partial discharge on the basis of the time difference $\Delta t$, the propagation velocity V1 of the partial discharge signal in the gas-insulated apparatus 1, and the propagation velocity V2 of the partial discharge signal in the power cable 2.

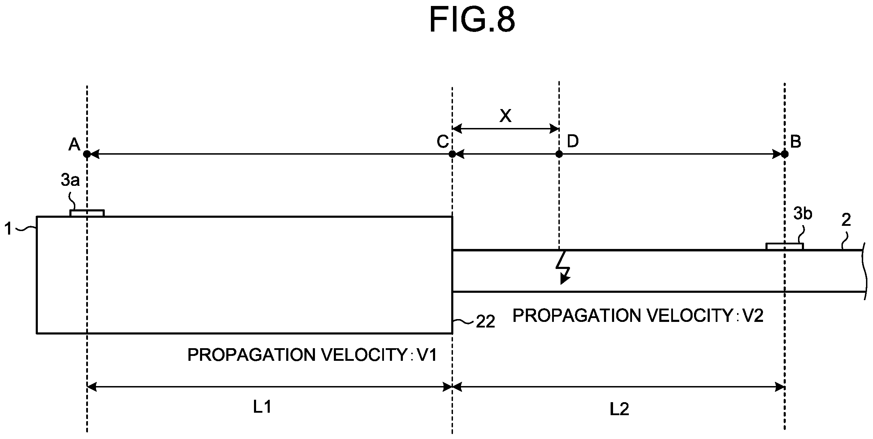

FIG. 8 is a diagram for explaining a method of calculating the location of occurrence of the partial discharge. In FIG. 8, the distance from a joint (C) between the gas-insulated apparatus 1 and the power cable 2, to the position (A) of the foil electrode 3a is denoted by L1, the distance from the joint (C) to the position (B) of the foil electrode 3b is denoted by L2, and the distance from the joint (C) to a discharge point (D) of a partial discharge is denoted by X. For the calculation of the location of occurrence of the partial discharge, distances in the direction of propagation of the partial discharge matter. Therefore, in FIG. 8, the gas-insulated apparatus 1 and the power cable 2 are drawn linearly to indicate the distances in the axial directions that are the directions of propagation. Here the axial directions are axial directions of the metal container 20 for the gas-insulated apparatus 1, and core directions for the power cable 2. The joint (C) is the connection end 22 of the power cable 2 to the gas-insulated apparatus 1, and is the boundary between the gas-insulated apparatus 1 and the power cable 2.

First, consider a case where X > 0. This case is where the partial discharge has occurred in the power cable 2. The time taken for the partial discharge signal to reach A from D is L1/V1 + X/V2. The time taken for the partial discharge to reach B from D is (L2 - X)/V2. Thus, when the detection time of the partial discharge signal at the foil electrode 3b is a reference, the time difference Δt is given by the following formula:

$$\Delta t = (L1/V1 + X/V2) - (L2 - X)/V2$$
$$= (L1/V1 - L2/V2) + 2X/V2$$
$$= \Delta t0 + 2X/V2 \quad \cdots (1)$$

Here, Δt0 is defined as Δt0 = (L1/V1 - L2/V2). In this case, as can be seen from (1), Δt - Δt0 is more than 0 (Δt - Δt0 > 0), that is, Δt is more than Δt0 (Δt > Δt0).

Next, consider a case where X is more than 0 (X < 0). This case is where the partial discharge has occurred in the gas-insulated apparatus 1. The time taken for the partial discharge signal to reach A from D is (L1 + X)/V1. The time taken for the partial discharge to reach B from D is (-X/V1 + L2/V2). Thus, when the detection time of the partial discharge signal at the foil electrode 3b is a reference, the time difference Δt is given by the following formula:

$$\Delta t = (L1 + X)/V1 - (-X/V1 + L2/V2)$$
$$= (L1/V1 - L2/V2) + 2X/V1$$
$$= \Delta t0 + 2X/V1 \quad \cdots (2)$$

In this case, as can be seen from (2), Δt - Δt0 is less than 0 (Δt - Δt0 < 0), that is, Δt is less than Δt0 (Δt < Δt0).

It is evident that Δt0 is the time difference when X = 0, that is, when the partial discharge has occurred at the joint (C).

Here, L1 and L2, which can be measured after the foil electrodes 3a, 3b are mounted, are known values. The measurement data on L1 and L2 is input to the processing unit 13 in advance. Further, permittivity data is input to the processing unit 13 in advance because the propagation velocity V1 of the partial discharge signal in the gas-insulated apparatus 1 is determined from the permittivity of the insulating gas, and the propagation velocity V2 of the partial discharge signal in the power cable 2 is determined from the permittivity of the insulator in the power cable 2. When sulfur hexafluoride ($SF_6$) gas is used as the insulating gas, sulfur hexafluoride ($SF_6$) gas has a relative permittivity that is nearly 1. When cross-linked polyethylene is used as the insulator of the power cable 2, the relative permittivity of cross-linked polyethylene is in the order of 2.3. Therefore, V1 is nearly the velocity of light, and V2 is about $1/\sqrt{(2.3)}$ times the velocity of light.

The processing unit 13 locates the partial discharge as follows. The processing unit 13 calculates V1, V2 from the input permittivity data, using the known relationships between the permitivity and the propagation velocity of the electromagnetic wave in the medium. Instead of the permittivity data, the data on V1, V2 may be input to the processing unit 13 in advance. The processing unit 13 calculates Δt0, using L1, L2, V1, and V2. Pre-calculated Δt0 may be input to the processing unit 13.

Next, the processing unit 13 compares the time difference Δt output from the counter 12 with the calculated value Δt0.

As a result of the comparison, when Δt is more than Δt0 (Δt > Δt0), which corresponds to the case of (1), X is thus given by

$$X = (\Delta t - \Delta t0) \times V2/2 \quad \cdots (3)$$

That is, when Δt is more than Δt0, (Δt > Δt0), X is more than 0 (X > 0), and it can be determined that the partial discharge has occurred in the power cable 2. The specific location is given by (3).

As a result of the comparison, when Δt is less than Δt0 (Δt < Δt0), which corresponds to the case of (2), X is thus given by

$$X = (\Delta t - \Delta t0) \times V1/2 \qquad \cdots (4)$$

That is, when $\Delta t$ is less than $\Delta t0$ ($\Delta t < \Delta t0$), X is less than 0 (X < 0), and it can be determined that the partial discharge has occurred in the gas-insulated apparatus 1. The specific location is given by (4).

As a result of the comparison, when $\Delta t$ is equal to $\Delta t0$ ($\Delta t = \Delta t0$), it can be determined that the partial discharge has occurred at the joint (C) as described above.

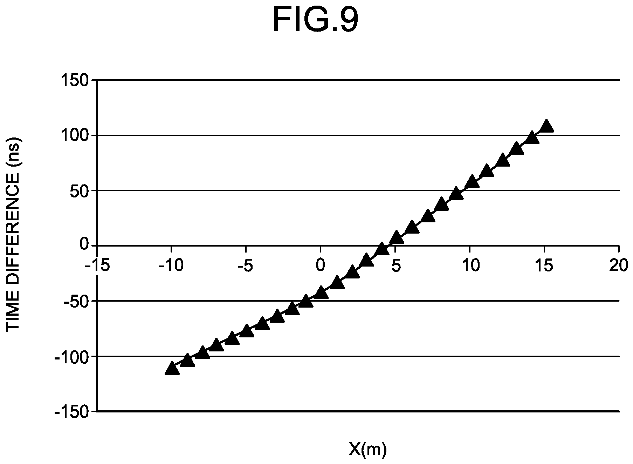

FIG. 9 is a graph illustrating an example of the relationship between the time difference and X when L1 is equal to 10 m (L1 = 10 m) and L2 is equal to 15 m (L2 = 15 m) in FIG. 8. The horizontal axis represents X(m), and the vertical axis represents the time difference (ns). This relationship is the result of calculations with V1 = 3.0 x 108 (m/s) and

$V2 = 1/\sqrt{(2.3)} \times V1$. The inclination changes from X = 0. This is because V1 is different from V2.

As described above, the partial discharge lacating apparatus according to the present embodiment includes the foil electrode 3a mounted to the gas-insulated apparatus 1, the foil electrode 3b mounted to the power cable 2, the time difference detecting unit 32 to detect a time difference that is a difference between the time of detection of the partial discharge signal by the foil electrode 3a and the time of detection of the partial discharge signal by the foil electrode 3b, and the processing unit 13 to locate the occurrence of the partial discharge on the basis of the time difference detected by the time difference detecting unit 32, the propagation velocity V1 of the partial discharge signal in the gas-insulated apparatus 1, and the propagation velocity V2 of the partial discharge signal in the power cable 2, and thus can identify, by the single measurement, in which one of the gas-insulated apparatus 1 and the power cable 2 the partial discharge has occured.

The partial discharge locating apparatus according to the present embodiment further includes the frequency selecting unit 31 to select the component of the predetermined detection frequency from the partial discharge signal output from the foil electrode 3a, and select the component of the detection frequency from the partial discharge signal output from the foil electrode 3b, so that the time difference detecting unit 32 can determine the time of detection of the partial discharge signal by the foil electrode 3a and the time of detection of the partial discharge signal by the foil electrode 3b on the basis of the components of the same detection frequency, thus improving the accuracy of time difference detection, and improving the locating accuracy.

It is also possible to determine the time of detection of the partial discharge signal by the foil electrode 3a and the time of detection of the partial discharge signal by the foil electrode 3b on the basis of components of different detection frequencies. In this case, however, the accuracy of time difference detection is low, compared to the present embodiment.

In the present embodiment, the SAW filters 6a and 6b select the upper sidebands of the outputs of the mixers 4a and 4b, and allow the passage of only the components of the specific frequency in the upper sidebands. This can increase the temporal resolution of the signal waveforms, thereby improving the accuracy of time difference detection and thus the locating accuracy.

The SAW filters 6a and 6b can alternatively select the lower sidebands of the outputs of the mixers 4a and 4b, and allow the passage of only the components of the specific frequency in the lower sidebands. In this case, however, the accuracy of time difference detection is low, compared to the present embodiment.

In the present embodiment, the AGC circuit 9a to adjust the amplitude of the output of the SAW filter 6a to the fixed magnitude, and the AGC circuit 9b to adjust the amplitude of the output of the SAW filter 6b to the fixed magnitude are provided. This can reduce the effect of the attenuation of the partial discharge signal due to the propagation and magnitude of the partial discharge with respect to the outputs of the SAW filters 6a and 6b, thereby improving the accuracy of time difference detection and thus the locating accuracy.

A configuration providing none of the AGC circuits 9a and 9b is possible. In this case, however, the accuracy of time difference detection is low, compared to the present embodiment.

In the present embodiment, the absolute value circuit 8a is disposed in the stage following the SAW filter 6a and preceding the AGC circuit 9a, and the absolute value circuit 8b is disposed in the stage following the SAW filter 6b and preceding the AGC circuit 9b. This enables the comparators 10a, 10b in the following stage to compare the partial discharge signal with the positive reference voltage V0 to thereby achieve the accurate detection of the time of the detection of the partial discharge, regardless of whether the partial discharge signal that has been modulated by the mixers 4a and 4b is detected at the rising edge or the falling edge.

It is also possible to determine the time of the detection of the partial discharge signal as in the present embodiment, by determining whether the partial discharge signal is larger than V0 or smaller than -V0 at the time difference detecting unit 32 without providing the absolute value circuits 8a and 8b.

In the present embodiment, the time difference detecting unit 32 is constituted by the comparators 10a and 10b, the reference voltage generation circuit 11, and the counter 12. This enables the accurate detection of the time difference by the simple configuration.

According to the present embodiment, the processing unit 13 can easily determine whether the partial discharge has occurred on the gas-insulated apparatus 1 side or on the power cable 2 side by comparing the magnitude of the detected time difference Δt with the magnitude of the pre-calculated Δt0, and can specifically determine the location of occurrence of the partial discharge, using the above-described (3) and (4). In particular, the configuration in the present embodiment improves the locating accuracy of the partial discharge, such that the error in locating the partial discharge that has occurred in a range of several meters including the boundary between the gas-insulated apparatus 1 and the power cable 2 can be reduced to a few centimeters.

In the present embodiment, the foil electrodes 3a and 3b are used as the first and second sensors. The foil electrodes 3a and 3b are easy to mount and demount, and have flexibility in the installation locations. Further, by making the foil electrodes 3a and 3b uniform in size and shape, the partial discharge can be detected by sensors of the same sensitivity. Furthermore, by using the foil electrodes 3a and 3b, the partial discharge locating apparatus according to the present embodiment can be made portable.

Alternatively, sensors other than the foil electrodes 3a and 3b can be used as the first and second sensors.

In the present embodiment, the frequency selecting unit 31 is configured to use the superheterodyne method. It is also possible to use another configuration to select components of a predetermined detection frequency.

The configuration described in the above embodiment illustrates an example of the subject matter of the present invention, and can be combined with a known technique, and can be partly omitted or changed without departing from the scope of the present invention. The scope of the invention is defined by the appended claims.

Reference Signs List

1 gas-insulated apparatus, 2 power cable, 2b braided wire, 2c sheath, 3a, 3b foil electrode, 4a, 4b mixer, 5 PLL synthesizer, 6a, 6b SAW filter, 7 frequency setting circuit, 8a, 8b absolute value circuit, 9a, 9b AGC circuit, 10a, 10b comparator, 11 reference voltage generation circuit, 12 counter, 13 processing unit, 14 display, 20 metal container, 21 cable head, 22 connection end, 25 insulator, 30 local oscillator, 31 frequency selecting unit, 32 time difference detecting unit.

**Claims**

1. A partial discharge locating apparatus capable of locating a partial discharge that has occurred in a power cable (2) or a gas-insulated apparatus (1) to which the power cable is connected, the partial discharge locating apparatus comprising:

   a first sensor (3a) mounted to the gas-insulated apparatus and capable of detecting a partial discharge signal;
   a second sensor (3b) mounted to the power cable and capable of detecting the partial discharge signal;
   a frequency selecting unit (31)

   connected to the first sensor (3a), and
   connected to the second sensor (3b),
   wherein the frequency selecting unit (31) is configured

   to select a first component of a first predetermined detection frequency from the partial discharge signal output from the first sensor (3a) and to output the selected first component, and
   to select a second component of a second predetermined detection frequency from the partial discharge signal output from the second sensor (3b) and to output the selected second component,
   wherein each respective predetermined detection frequency is the frequency used for the detection of the partial discharge signal output from the corresponding sensor; and

   a time difference detecting unit (32) configured to detect, on the basis of the output selected first and second components, a time difference that is a difference between a time of detection of the partial discharge signal by the first sensor and a time of detection of the partial discharge signal by the second sensor; and
   a processing unit (13) configured to locate occurrence of the partial discharge on the basis of

   the time difference detected by the time difference detecting unit,
   the distance(L1) from the first sensor (3a) to the connection between the gas-insulated apparatus (1) and the power cable (2),

the distance (L2) from the second sensor (3b) to the connection between the gas-insulated apparatus (1) and the power cable (2),
a propagation velocity (V1) of the partial discharge signal in the gas-insulated apparatus (1), and
a propagation velocity (V2) of the partial discharge signal in the power cable (2).

2. A partial discharge locating apparatus according to claim 1,
wherein the first and second predetermined detection frequencies are the same predetermined detection frequency for the partial discharge signal output from the first sensor (3a) and the partial discharge signal output from the second sensor (3b).

3. The partial discharge locating apparatus according to claim 2, wherein the frequency selecting unit (31) comprises

a local oscillator (30) operable to generate a local oscillation signal of a local oscillation frequency;
a first mixer (4a) operable to mix the partial discharge signal output by the first sensor (3a) with the local oscillation signal and to output the mixed signal as a first mixed signal;
a first filter (6a) configured to allow passage of only a passing frequency, being a component of the first mixed signal output by the first mixer (4a), the passing frequency being the sum of the predetermined detection frequency and the local oscillation frequency;
a second mixer (4b) operable to mix the partial discharge signal output by the second sensor (3b) with the local oscillation signal; and to output the mixed signal as a second mixed signal
a second filter (6b) configured to allow passage of only the passing frequency, being a component of the second mixed signal output by the second mixer (4b), the second filter having a same frequency as the first filter.

4. A partial discharge locating apparatus according to claim 3, comprising:

a first amplitude adjustment circuit (9a) operable to adjust an amplitude of an output of the first filter (6a) to a fixed magnitude; and
a second amplitude adjustment circuit operable to adjust an amplitude of an output of the second filter (6b) to the fixed magnitude, wherein
the time difference detecting unit (32) detects the time difference on a basis of an output of the first amplitude adjustment circuit and an output of the second amplitude adjustment circuit.

5. A partial discharge locating apparatus according to claim 4, comprising:

a first absolute value circuit (8a) operable to output an absolute value of the output of the first filter (6a) to the first amplitude adjustment circuit (9a), the first absolute value circuit being disposed in a stage following the first filter (6a) and preceding the first amplitude adjustment circuit (9a); and
a second absolute value circuit (8b) operable to output an absolute value of the output of the second filter (6b) to the second amplitude adjustment circuit (9b), the second absolute value circuit being disposed in a stage following the second filter (6b) and preceding the second amplitude adjustment circuit (9b).

6. A partial discharge locating apparatus according to claim 5, wherein
the time difference detecting unit (32) comprises:

a first comparator (10a) configured to output different values depending on whether the output of the first amplitude adjustment circuit (9a) is larger or smaller than a reference voltage;
a second comparator (10b) configured to output different values depending on whether the output of the second amplitude adjustment circuit (9b) is larger or smaller than the reference voltage; and
a counter (12) operable to count the time difference on a basis of

an output of the first comparator (10a), and
an output of the second comparator (10b).

7. A partial discharge locating apparatus according to any one of claims 1 to 6, wherein the processing unit (13) is operable to compare the time difference with a calculated value of (L1/V1 - L2/V2) where L1 is a distance from the connection between the gas-insulated apparatus (1) and the power cable (2), to a position of the first sensor (3a), L2 is a distance from the connection to a position of the second sensor (3b), V1 is the propagation velocity of the partial discharge signal in the gas-insulated apparatus, and V2 is the propagation velocity of the partial discharge signal in the power cable, and wherein the processing unit is further configured to determine:

that the partial discharge has occurred in the power cable when the time difference is larger than the calculated value of (L1/V1 - L2/V2); and

that the partial discharge has occurred in the gas-insulated apparatus when the time difference is smaller than the calculated value of (L1/V1 - L2/V2); and

that the partial discharge has occurred at the connection when the time difference is equal to the calculated value of (L1/V1 - L2/V2).

8. A partial discharge locating apparatus according to any one of claims 1 to 7, wherein

the first and second sensors (3a, 3b) are each a foil electrode,

the first sensor (3a) is mounted on a metal container (20) of the gas-insulated apparatus (1) via an insulator (25), and

the second sensor (3b) is mounted on the power cable (2) .

**Patentansprüche**

1. Teilentladungslokalisierungsvorrichtung, die geeignet ist, eine Teilentladung zu lokalisieren, die in einem Stromversorgungskabel (2) oder einer gasisolierten Vorrichtung (1), mit der das Stromversorgungskabel verbunden ist, aufgetreten ist, wobei die Teilentladungslokalisierungsvorrichtung Folgendes umfasst:

einen ersten Sensor (3a), der an der gasisolierten Vorrichtung angebracht und geeignet ist, ein Teilentladungssignal zu detektieren,

einen zweiten Sensor (3b), der an dem Stromversorgungskabel angebracht und geeignet ist, das Teilentladungssignal zu detektieren;

eine Frequenzauswahleinheit (31),

die mit dem ersten Sensor (3a), und

mit dem zweiten Sensor (3b) verbunden ist,

wobei die Frequenzauswahleinheit (31) konfiguriert ist,

eine erste Komponente einer ersten vorbestimmten Detektionsfrequenz aus dem von dem ersten Sensor (3a) ausgegebenen Teilentladungssignal auszuwählen und die ausgewählte erste Komponente auszugeben, und

eine zweite Komponente einer zweiten vorbestimmten Detektionsfrequenz aus dem von dem zweiten Sensor (3b) ausgegebenen Teilentladungssignal auszuwählen und die ausgewählte zweite Komponente auszugeben, wobei jede jeweilige vorbestimmte Detektionsfrequenz die für die Detektion des von dem entsprechenden Sensor ausgegebenen Teilentladungssignals verwendete Frequenz ist; und

eine Zeitdifferenzdetektionseinheit (32), die konfiguriert ist, auf Basis der ausgegebenen ausgewählten ersten und zweiten Komponente eine Zeitdifferenz zu detektieren, die eine Differenz zwischen einer Zeit des Detektierens des Teilentladungssignals durch den ersten Sensor und einer Zeit des Detektierens des Teilentladungssignals durch den zweiten Sensor ist; und

eine Verarbeitungseinheit (13), die konfiguriert ist, ein Auftreten der Teilentladung auf Basis von Folgendem zu lokalisieren:

der durch die Zeitdifferenzdetektionseinheit detektierten Zeitdifferenz,

der Distanz (L1) vom ersten Sensor (3a) zur Verbindung zwischen der gasisolierten Vorrichtung (1) und dem Stromversorgungskabel (2),

der Distanz (L2) vom zweiten Sensor (3b) zur Verbindung zwischen der gasisolierten Vorrichtung (1) und dem Stromversorgungskabel (2),

einer Ausbreitungsgeschwindigkeit (V1) des Teilentladungssignals in der gasisolierten Vorrichtung (1), und

einer Ausbreitungsgeschwindigkeit (V2) des Teilentladungssignals im Stromversorgungskabel (2).

2. Teilentladungslokalisierungsvorrichtung gemäß Anspruch 1,
wobei die erste und die zweite vorbestimmte Detektionsfrequenz dieselbe vorbestimmte Detektionsfrequenz für das aus dem ersten Sensor (3a) ausgegebene Teilentladungssignal und das aus dem zweiten Sensor (3b) ausgegebene Teilentladungssignal sind.

3. Teilentladungslokalisierungsvorrichtung gemäß Anspruch 2,

wobei die Frequenzauswahleinheit (31) Folgendes umfasst:

einen lokalen Oszillator (30), der ausgelegt ist, ein lokales Schwingungssignal von einer lokalen Schwingungsfrequenz zu erzeugen;

einen ersten Mischer (4a), der ausgelegt ist, das von dem ersten Sensor (3a) ausgegebene Teilentladungssignal mit dem lokalen Schwingungssignal zu mischen und das Mischsignal als ein erstes Mischsignal auszugeben;

ein erstes Filter (6a), das konfiguriert ist, lediglich das Durchlassen von Durchlassfrequenz zu ermöglichen, die eine Komponente des von dem ersten Mischer (4a) ausgegebenen, ersten Mischsignals ist, wobei die Durchlassfrequenz die Summe der vorbestimmten Detektionsfrequenz und der lokalen Schwingungsfrequenz ist;

einen zweiten Mischer (4b), der ausgelegt ist, das von dem zweiten Sensor (3b) ausgegebene Teilentladungssignal mit dem lokalen Schwingungssignal zu mischen; und das Mischsignal als ein zweites Mischsignal auszugeben;

ein zweites Filter (6b), das konfiguriert ist, lediglich das Durchlassen der Durchlassfrequenz zu ermöglichen, die eine Komponente des von dem zweiten Mischer (4b) ausgegebenen, zweiten Mischsignals ist, wobei das zweite Filter dieselbe Frequenz wie das erste Filter aufweist.

4. Teilentladungslokalisierungsvorrichtung gemäß Anspruch 3, umfassend:

eine erste Amplitudeneinstellschaltung (9a), die ausgelegt ist, eine Amplitude einer Ausgabe des ersten Filters (6a) auf eine festgelegte Größe einzustellen; und

eine zweite Amplitudeneinstellschaltung, die ausgelegt ist, eine Amplitude einer Ausgabe des zweiten Filters (6b) auf die festgelegte Größe einzustellen,

wobei die Zeitdifferenzdetektionseinheit (32) die Zeitdifferenz auf Basis einer Ausgabe der ersten Amplitudeneinstellschaltung und einer Ausgabe der zweiten Amplitudeneinstellschaltung detektiert.

5. Teilentladungslokalisierungsvorrichtung gemäß Anspruch 4, umfassend:

eine erste Absolutwertschaltung (8a), die ausgelegt ist, einen absoluten Wert der Ausgabe des ersten Filters (6a) an die erste Amplitudeneinstellschaltung (9a) auszugeben, wobei die erste Absolutwertschaltung in einer Phase angeordnet ist, die auf das erste Filter (6a) folgt und der ersten Amplitudeneinstellschaltung (9a) vorausgeht; und

eine zweite Absolutwertschaltung (8b), die ausgelegt ist, einen absoluten Wert der Ausgabe des zweiten Filters (6b) an die zweite Amplitudeneinstellschaltung (9b) auszugeben, wobei die zweite Absolutwertschaltung in einer Phase angeordnet ist, die auf das zweite Filter (6b) folgt und der zweiten Amplitudeneinstellschaltung (9b) vorausgeht.

6. Teilentladungslokalisierungsvorrichtung gemäß Anspruch 5,
wobei die Zeitdifferenzdetektionseinheit (32) Folgendes umfasst:

einen ersten Komparator (10a), der konfiguriert ist, unterschiedliche Werte in Abhängigkeit davon auszugeben, ob die Ausgabe der ersten Amplitudeneinstellschaltung (9a) größer oder kleiner als eine Referenzspannung ist;

einen zweiten Komparator (10b), der konfiguriert ist, unterschiedliche Werte in Abhängigkeit davon auszugeben, ob die Ausgabe der zweiten Amplitudeneinstellschaltung (9b) größer oder kleiner als die Referenzspannung ist; und

einen Zähler (12), der ausgelegt ist, die Zeitdifferenz auf Basis
einer Ausgabe des ersten Komparators (10a), und
einer Ausgabe des zweiten Komparators (10b)

zu zählen.

7. Teilentladungslokalisierungsvorrichtung gemäß einem der Ansprüche 1 bis 6,
wobei die Verarbeitungseinheit (13) ausgelegt ist, die Zeitdifferenz mit einem berechneten Wert von (L1/V1 - L2/V2) zu vergleichen, worin L1 ein Abstand von der Verbindung zwischen der gasisolierten Vorrichtung (1) und dem Stromversorgungskabel (2) zu einer Position des ersten Sensors (3a) ist, L2 ein Abstand von der Verbindung zu einer Position des zweiten Sensors (3b) ist, V1 die Ausbreitungsgeschwindigkeit des Teilentladungssignals in der gasisolierten Vorrichtung ist, und V2 die Ausbreitungsgeschwindigkeit des Teilentladungssignals im Stromversorgungskabel ist, und wobei die Verarbeitungseinheit ferner konfiguriert ist, Folgendes zu bestimmen:

dass die Teilentladung im Stromversorgungskabel aufgetreten ist, wenn die Zeitdifferenz größer als der berechnete Wert von (L1/V1 - L2/V2) ist; und

dass die Teilentladung in der gasisolierten Vorrichtung aufgetreten ist, wenn die Zeitdifferenz kleiner als der berechnete Wert von (L1/V1 - L2/V2) ist; und

dass die Teilentladung an der Verbindung aufgetreten ist, wenn die Zeitdifferenz gleich dem berechneten Wert von (L1/V1 - L2/V2) ist.

8. Teilentladungslokalisierungsvorrichtung gemäß einem der Ansprüche 1 bis 7,

wobei der erste und der zweite Sensor (3a, 3b) jeweils eine Folienelektrode sind,

wobei der erste Sensor (3a) über einen Isolator (25) auf einem Metallbehälter (20) der gasisolierten Vorrichtung (1) angebracht ist, und

wobei der zweite Sensor (3b) auf dem Stromversorgungskabel (2) angebracht ist.

## Revendications

1. Appareil de localisation de décharge partielle apte à localiser une décharge partielle qui s'est produite dans un câble d'alimentation électrique (2) ou un appareil à isolation gazeuse (1) auquel le câble d'alimentation électrique est raccordé, l'appareil de localisation de décharge partielle comprenant :

un premier capteur (3a) fixé à l'appareil à isolation gazeuse et apte à détecter un signal de décharge partielle ;

un second capteur (3b) fixé au câble d'alimentation électrique et apte à détecter le signal de décharge partielle ;

une unité de sélection de fréquence (31)

raccordée au premier capteur (3a) et

raccordée au second capteur (3b),

dans lequel l'unité de sélection de fréquence (31) est configurée

pour sélectionner une première composante d'une première fréquence de détection prédéterminée dans le signal de décharge partielle émis par le premier capteur (3a) et pour émettre la première composante sélectionnée, et

pour sélectionner une seconde composante d'une seconde fréquence de détection prédéterminée dans le signal de décharge partielle émis par le second capteur (3b) et pour émettre la seconde composante sélectionnée,

dans lequel chaque fréquence de détection prédéterminée est la fréquence utilisée pour la détection du signal de décharge partielle émis par le capteur correspondant ; et

une unité de détection de différence de temps (32) configurée pour détecter, sur la base des première et seconde composantes sélectionnées émises, une différence de temps qui est une différence entre un temps de détection du signal de décharge partielle par le premier capteur et un temps de détection du signal de décharge partielle par le second capteur ; et

une unité de traitement (13) configurée pour localiser l'endroit où s'est produite la décharge partielle sur la base de la différence de temps détectée par l'unité de détection de différence de temps,

la distance (L1) du premier capteur (3a) au raccord entre l'appareil à isolation gazeuse (1) et le câble d'alimentation électrique (2),

la distance (L2) du second capteur (3b) au raccord entre l'appareil à isolation gazeuse (1) et le câble d'alimentation électrique (2),

une vitesse de propagation (V1) du signal de décharge partielle dans l'appareil à isolation gazeuse (1), et

une vitesse de propagation (V2) du signal de décharge partielle dans le câble d'alimentation électrique (2).

2. Appareil de localisation de décharge partielle selon la revendication 1,

dans lequel les première et seconde fréquences de détection prédéterminées sont une même fréquence de détection prédéterminée du signal de décharge partielle émis par le premier capteur (3a) et du signal de décharge partielle émis par le second capteur (3b).

3. Appareil de localisation de décharge partielle selon la revendication 2, dans lequel

l'unité de sélection de fréquence (31) comprend :

un oscillateur local (30) utilisable pour générer un signal d'oscillation local d'une fréquence d'oscillation locale ;

un premier mélangeur (4a) utilisable pour mélanger le signal de décharge partielle émis par le premier capteur (3a) avec le signal d'oscillation local et pour émettre le signal mélangé en tant que premier signal mélangé ;

un premier filtre (6a) configuré pour autoriser le passage seulement d'une fréquence passante qui est une composante du premier signal mélangé émis par le premier mélangeur (4a), la fréquence passante étant la somme de la fréquence de détection prédéterminée et de la fréquence d'oscillation locale ;
un second mélangeur (4b) utilisable pour mélanger le signal de décharge partielle émis par le second capteur (3b) avec le signal d'oscillation local ; et pour émettre le signal mélangé en tant que second signal mélangé ;
un second filtre (6b) configuré pour autoriser le passage seulement de la fréquence passante qui est une composante du second signal mélangé émis par le second mélangeur (4b), le second filtre ayant la même fréquence que le premier filtre.

4. Appareil de localisation de décharge partielle selon la revendication 3, comprenant :

un premier circuit de réglage d'amplitude (9a) utilisable pour régler une amplitude d'une sortie du premier filtre (6a) sur une grandeur fixe ; et
un second circuit de réglage d'amplitude utilisable pour régler une amplitude d'une sortie du second filtre (6b) sur la grandeur fixe, dans lequel
l'unité de détection de différence de temps (32) détecte la différence de temps sur la base d'une sortie du premier circuit de réglage d'amplitude et d'une sortie du second circuit de réglage d'amplitude.

5. Appareil de localisation de décharge partielle selon la revendication 4, comprenant :

un premier circuit de valeur absolue (8a) utilisable pour transmettre une valeur absolue de la sortie du premier filtre (6a) au premier circuit de réglage d'amplitude (9a), le premier circuit de valeur absolue étant disposé dans un étage qui suit le premier filtre (6a) et qui précède le premier circuit de réglage d'amplitude (9a) ; et
un second circuit de valeur absolue (8b) utilisable pour transmettre une valeur absolue de la sortie du second filtre (6b) au second circuit de réglage d'amplitude (9b), le second circuit de valeur absolue étant disposé dans un étage qui suit le second filtre (6b) et qui précède le second circuit de réglage d'amplitude (9b).

6. Appareil de localisation de décharge partielle selon la revendication 5, dans lequel
l'unité de détection de différence de temps (32) comprend :

un premier comparateur (10a) configuré pour produire des valeurs différentes selon que la sortie du premier circuit de réglage d'amplitude (9a) est supérieure ou inférieure à une tension de référence ;
un second comparateur (10b) configuré pour produire des valeurs différentes selon que la sortie du second circuit de réglage d'amplitude (9b) est supérieure ou inférieure à la tension de référence ; et
un compteur (12) utilisable pour compter la différence de temps sur la base
d'une sortie du premier comparateur (10a) et
d'une sortie du second comparateur (10b).

7. Appareil de localisation de décharge partielle selon l'une quelconque des revendications 1 à 6, dans lequel l'unité de traitement (13) est utilisable pour comparer la différence de temps avec une valeur calculée de (L1/V1 - L2/V2) où L1 est une distance du raccord entre l'appareil à isolation gazeuse (1) et le câble d'alimentation électrique (2) à une position du premier capteur (3a), L2 est une distance du raccord à une position du second capteur (3b), V1 est la vitesse de propagation du signal de décharge partielle dans l'appareil à isolation gazeuse, et V2 est la vitesse de propagation du signal de décharge partielle dans le câble d'alimentation électrique, et dans lequel l'unité de traitement est configurée en outre pour déterminer :

que la décharge partielle s'est produite dans le câble d'alimentation électrique lorsque la différence de temps est supérieure à la valeur calculée de (L1/V1 - L2/V2) ; et
que la décharge partielle s'est produite dans l'appareil à isolation gazeuse lorsque la différence de temps est inférieure à la valeur calculée de (L1/V1 - L2/V2) ; et
que la décharge partielle s'est produite au niveau du raccord lorsque la différence de temps est égale à la valeur calculée de (L1/V1 - L2/V2).

8. Appareil de localisation de décharge partielle selon l'une quelconque des revendications 1 à 7, dans lequel
les premier et second capteurs (3a, 3b) sont chacun une électrode en feuille,
le premier capteur (3a) est fixé sur un récipient métallique (20) de l'appareil à isolation gazeuse (1) par l'intermédiaire d'un isolateur (25), et
le second capteur (3b) est fixé sur le câble d'alimentation électrique (2).

FIG.1

FIG.2

(a)

(b)

# FIG.3

EP 3 223 025 B1

# FIG.4

(a)

(b)

(c)

# FIG.5

(a)

(b)

(c)

# FIG.6

VOLTAGE

V0

TIME

# FIG.7

VOLTAGE

Δt

t1    t2

TIME

# FIG.8

EP 3 223 025 B1

# FIG.9

**EP 3 223 025 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4070573 A

- JP 9229991 A